# EUROPÄISCHE PATENTSCHRIFT

(11) **EP 1 191 693 B1**
(45) Veröffentlichungstag und Bekanntmachung des Hinweises auf die Patenterteilung: **18.01.2006**
(21) Anmeldenummer: 01120252.0
(22) Anmeldetag: 23.08.2001
(51) Int. Cl.: H03K 17/081

(54) **Schaltungsanordnung zur Erfassung des Stromes in einem Lasttransistor**
Circuit for monitoring the current through a power transistor
Circuit pour surveiller le courant dans un transistor de puissance

(30) Priorität: 30.08.2000 DE 10042585
(43) Veröffentlichungstag der Anmeldung: 27.03.2002
(73) Patentinhaber: Infineon Technologies AG, 81669 München (DE)
(72) Erfinder: Sander, Rainald, 81541 München (DE)
(74) Vertreter: Bickel, Michael

(56) Entgegenhaltungen:
- EP-A- 0 561 386
- EP-A- 0 743 751
- US-A- 6 057 728
- PATENT ABSTRACTS OF JAPAN vol. 2000, no. 11, 3. Januar 2001 (2001-01-03) & JP 2000 236246 A (YAZAKI CORP), 29. August 2000 (2000-08-29)

## Beschreibung

Die vorliegende Erfindung betrifft eine Schaltungsanordnung mit einem Lasttransistor und einem an den Lasttransistor gekoppelten Stromfühltransistor gemäß den Merkmalen des Oberbegriffs des Patentanspruchs 1.

Zur Erfassung des Stromes durch einen Lasttransistor, der zum Schalten einer Last dient, ist es bekannt, dem Lasttransistor einen Transistor als Stromfühltransistor parallel zu schalten, welcher im selben Arbeitspunkt wie der Lasttransistor betrieben wird. Eine Schaltungsanordnung mit einem Lasttransistor und einem parallel zu dem Lasttransistor geschalteten Stromfühltransistor ist beispielsweise in der JP 2000236246 A beschrieben.

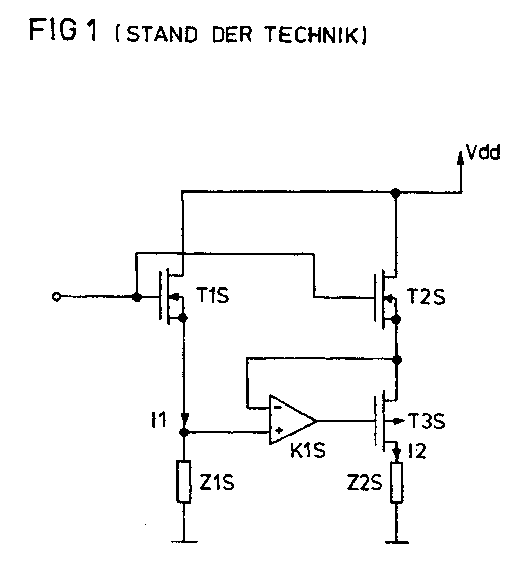

Figur 1 zeigt eine derartige, auch als Strom-Sense-Anordnung bezeichnete, Schaltungsanordnung nach dem Stand der Technik.

Die Schaltungsanordnung weist einen Lasttransistor T1S auf, welcher in Reihe zu einer Last Z1S zwischen einem Versorgungspotential Vdd und einem Bezugspotential GND verschaltet ist. Parallel zu dem Lasttransistor T1S ist ein Stromfühltransistor T2S angeordnet, dessen Gate-Anschluss an den Gate-Anschluß des Lasttransistors T1S und dessen Drain-Anschluss mit dem Drain-Anschluss des Lasttransistors T1S an ein Versorgungspotential Vdd angeschlossen ist. Dem Source-Anschluss des Stromfühltransistors T2S ist eine Reihenschaltung eines Transistors T3S und eines Stromfühlwiderstandes Z2S nachgeschaltet. Der Transistor T3S wird dabei mittels eines Komparators K1S angesteuert, welcher die Source-Potentiale des Lasttransistors T1S und des Stromfühltransistors T2S miteinander vergleicht, um sie auf denselben Wert einzustellen. Der Strom I2 durch den Stromfühltransistor T2S ist dann proportional zu dem Strom Il durch den Lasttransistor T1S, wobei das Verhältnis dieser beiden Ströme von dem Verhältnis der Dimensionierungen des Lasttransistors T1S und des Stromfühltransistors T2S abhängt.

Es ist auch bekannt, aus z.B JP 2002 252 803, einen von einem Stromfühltransistor gemäß Figur 1 gelieferten Strom anderen Anwendungsschaltungen als der in Figur 1 dargestellten zuzuführen. Für jede der Auswerteschaltungen ist dabei bei bekannten Schaltungsanordnungen ein eigener Stromfühltransistor vorgesehen.

Üblicherweise sind der Lasttransistor und der zugehörige Stromfühltransistor in einem Chip integriert, während Auswerteschaltungen in einem weiteren Chip integriert sind. Dabei ist zwischen jedem der Stromfühltransistoren in dem einen Chip und der zugehörigen Verarbeitungsschaltung im anderen Chip eine Leitungsverbindung erforderlich, das bedeutet, für jede dieser Verbindungen ist an dem ersten und zweiten Chip ein Kontaktpin erforderlich.

Ziel der vorliegenden Erfindung ist es, eine Schaltungsanordnung zur Auswertung des Laststromes eines Lasttransistors zur Verfügung zu stellen, welche mit bekannten Schaltungsmitteln einfach realisiert werden kann und bei welcher insbesondere die oben genannten Nachteile nicht auftreten.

Dieses Ziel wird durch eine Schaltungsanordnung gemäß den Merkmalen des Patentanspruchs 1 gelöst.

Vorteilhafte Ausgestaltungen der Erfindung sind Gegenstand der Unteransprüche.

Die erfindungsgemäße Schaltungsanordnung weist einen Lasttransistor und einen an den Lasttransistor gekoppelten Stromfühltransistor auf, wobei dem Stromfühltransistor eine Schalteranordnung mit wenigstens einem Schalter nachgeschaltet ist, um den Stromfühltransistor abhängig von einem Steuersignal an eine erste oder zweite Auswerteschaltung anzuschließen.

Bei der erfindungsgemäßen Schaltungsanordnung ist lediglich ein Stromfühltransistor erforderlich, dessen Ausgangsstrom über die Schalteranordnung bedarfsgerecht einer der Auswerteschaltungen zugeführt werden kann.

Gemäß einer Ausführungsform der Erfindung ist vorgesehen, daß die Schalteranordnung abhängig von einer Laststreckenspannung (Drain-Source-Spannung) des Lasttransistors ansteuerbar ist. So besteht die Möglichkeit, als eine Auswerteschaltung Schaltungskomponenten vorzusehen, welche den Stromfühlwiderstand zu einer herkömmlichen Strom-Sense-Schaltung nach Figur 1 ergänzen, wobei dieser Auswerteschaltung der Strom des Stromfühlwiderstandes nur bis zum Erreichen einer vorgegebenen Drain-Source-Spannung des Lasttransistors zugeführt wird. Herkömmliche Strom-Sense-Schaltungen liefern nur dann ein Stromsignal, welches proportional zu dem Laststrom ist, wenn sich der Lasttransistor noch nicht in Sättigung befindet, wenn sich die Drain-Source-Spannung also unterhalb einer Sättigungsspannung befindet. Mittels der erfindungsgemäßen Schaltungsanordnung kann der Strom des Stromfühlwiderstandes einer anderen Auswerteschaltung zugeführt werden, wenn die Drain-Source-Spannung den Wert der Sättigungsspannung erreicht und der Strom des Stromfühlwiderstandes in der Strom-Sense-Anordnung ohnehin nicht mehr geeignet ausgewertet werden kann.

Gemäß einer weiteren Ausführungsform der Erfindung ist es vorgesehen, daß der Lasttransistor und der Stromfühltransistor in einem ersten Chip integriert sind, und daß die Schalteranordnung und die erste und zweite Auswerteschaltung in einem zweiten Chip integriert sind. Bei dieser Ausführungsform der Erfindung ist zwischen dem ersten Chip und dem zweiten Chip nur eine Leitungsverbindung erforderlich, um den Auswerteschaltungen den Laststrom des Stromfühlwiderstandes zuführen zu können.

Die vorliegende Erfindung wird nachfolgend in Ausführungsbeispielen anhand von Figuren näher erläutert. Es zeigt:
- Figur 1:: eine Strom-Sense-Anordnung nach dem Stand der Technik;
- Figur 2:: eine erfindungsgemäße Schaltungsanordnung gemäß einer Ausführungsform der Erfindung;
- Figur 3:: eine erfindungsgemäße Schaltungsanordnung gemäß Figur 2 mit detaillierter Darstellung der Schalteranordnung und eines Ausführungsbeispiels für die erste und zweite Verarbeitungseinheit.

In den Figuren bezeichnen, sofern nicht anders angegeben, gleiche Bezugszeichen gleiche Bauteile mit gleicher Bedeutung.

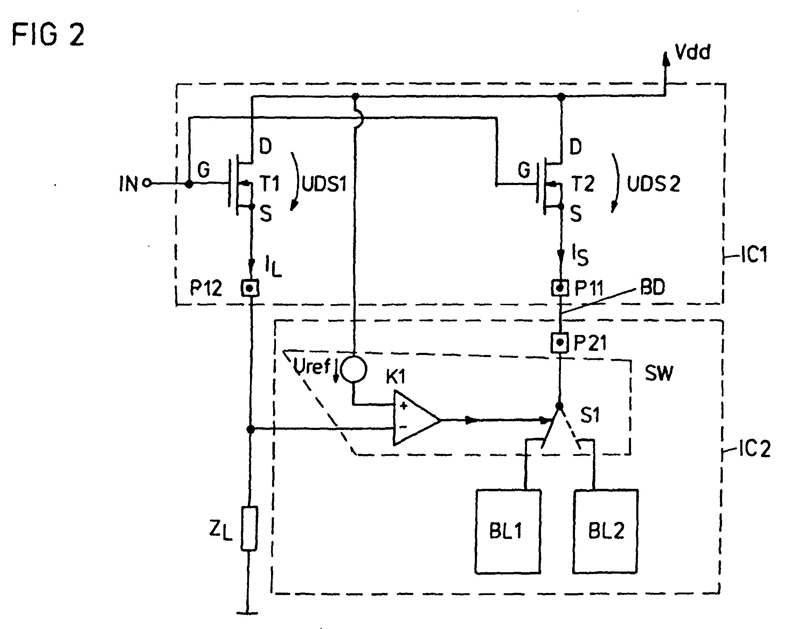

Figur 2 zeigt ein Ausführungsbeispiel der erfindungsgemäßen Schaltungsanordnung. Die Schaltungsanordnung weist einen Lasttransistor T1 und einen Stromfühltransistor T2 auf, die in dem Ausführungsbeispiel als n-Kanal-MOS-Transistoren ausgebildet sind. Ein Drain-Anschluss D des Lasttransistors T1 und ein Drain-Anschluss D es Stromfühltransistors T2 sind an ein Versorgungspotential Vdd. Ein Gate-Anschlus des Lasttransistors T1 und ein Gate-Anschluss des Stromfühltransistors T2 sind gemeinsam an eine Eingangsklemme IN zur Zuführung eines Ansteuersignals angeschlossen, nach dessen Maßgabe der Lasttransistor (und der Stromfühltransistor) leitet oder sperrt. Der Lasttransistor T1 und der Stromfühltransistor T2 sind vorzugsweise in einem Halbleiterkörper integriert, welcher eine Vielzahl von gleichartig aufgebauten Transistorzellen aufweist, wobei ein Teil der Transistorzellen (üblicherweise der größte Teil) zur Bildung des Lasttransistors T1 und ein Teil der Transistorzellen (üblicherweise ein kleiner Teil) zur Bildung des Stromfühltransistors T2 miteinander verschaltet sind. Zwischen einen Source-Anschluss S des Lasttransistors T1 und ein Bezugspotential GND ist eine Last Z_{L} geschaltet, welche mittels des Lasttransistors T1 angesteuert wird. Der Source-Anschluss S des Stromfühltransistors T2 ist an eine Schalteranordnung SW angeschlossen, welche den Source-Anschluss S abhängig von einer Schalterstellung eines Schalters S1 mit einer ersten oder einer zweiten Auswerteeinheit BL1, BL2 verbindet. Diese Schalteranordnung SW weist einen ersten Komparator K1 als Vergleichereinheit auf, dessen einer Anschluss an den Source-Anschluss S des Lasttransistors T1 und dessen anderer Anschluss über eine Referenzspannungsquelle Uref an das Versorgungspotential Vdd angeschlossen ist.

Ein Ausgangssignal des Komparators K1 nimmt einen oberen Ansteuerpegel an, wenn eine über der Drain-Source-Strecke D-S des Lasttransistors T1 anliegende Drain-Source-Spannung UDS1 größer als die Referenzspannung Uref ist, und das Ausgangssignal AS nimmt einen unteren Ansteuerpegel an, wenn die Drain-Source-Spannung UDS1 kleiner als die Referenzspannung Uref ist. Der Schalter S1, welcher durch das Ansteuersignal AS angesteuert ist, verbindet abhängig von dem Pegel des Ansteuersignals AS die erste Auswerteschaltung BL1 oder die zweite Auswerteschaltung BL2 mit dem Source-Anschluss S des Stromfühltransistors T2, um der ersten oder zweiten Auswerteschaltung den Laststrom des Stromfühltransistors T2 zuzuführen.

Der Lasttransistor T1 und der Stromfühltransistor T2 sind vorzugsweise in einem ersten Chip IC1 integriert, während die Schalteranordnung S und die Ansteuerschaltungen BL1, BL2 vorzugsweise in einem zweiten Chip IC2 integriert sind. Der Laststrom Iₛ des Stromfühltransistors T2 steht an einem ersten Anschlusspin P11 des ersten Chips IC1 zur Verfügung und wird dem zweiten Chip IC2 über einen Anschlusspin P21 zugeführt. Die Anschlusspins P11, P21 sind dabei mittels eines Bonddrahtes BD miteinander verbunden sind. Die üblicherweise externe Last Z_{L} ist an einen zweiten Anschlusspin P12 des ersten Chips IC1 angeschlossen. Der zweiten Eingang des Komparators K1 kann dabei ebenfalls an diesen zweiten Anschlusspin P12 angeschlossen sein, so daß hierfür keine separate Verbindung zwischen dem ersten Chip IC1 und dem zweiten Chip IC2 erforderlich ist. Der zweite Chip IC2 weist einen eigenen, nicht näher dargestellten Anschlusspin für das Versorgungspotential Vdd auf, so daß der erste Anschluss des Komparators K1 über die Referenzspannungsquelle Uref nicht in dem ersten Chip IC1 an das Versorgungspotential Vdd angeschlossen werden muss, was in Figur 2 lediglich aus Gründen der Einfachheit so dargestellt ist.

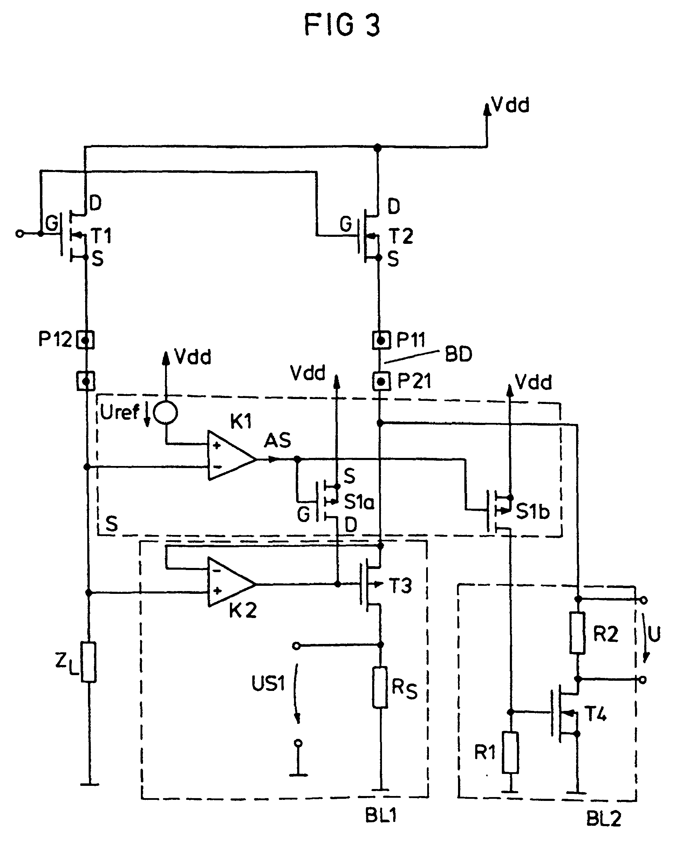

Figur 3 zeigt ein Ausführungsbeispiel der erfindungsgemäßen Schaltungsanordnung, bei welcher jeweils ein Ausführungsbeispiel für den Aufbau der ersten Auswerteschaltung BL1 und der zweiten Auswerteschaltung BL2 dargestellt ist.

Die erste Auswerteschaltung BL1 ergänzt den Stromfühltransistor T2 in dem Beispiel zu einer Strom-Sense-Schaltung. Die Auswerteschaltung BL1 weist einen Regeltransistor T3 auf, welcher über die Anschlusspins P21, P11 der ersten und zweiten Chips IC1, IC2 in Reihe zu dem Stromfühltransistor T2 geschaltet ist. Zwischen den Regeltransistor T3 und Bezugspotential GND ist ein Stromfühlwiderstand Rs geschaltet. Der Regeltransistor T3, der in dem Ausführungsbeispiel als p-Kanal-Transistor ausgebildet ist, wird durch einen zweiten Komparator K2 angesteuert, dessen erster Eingang (Minus-Eingang) an den Anschlusspin P21 des zweiten Chips IC2 bzw. an den Source-Anschluss S des Stromfühltransistors T2 angeschlossen ist. Ein zweiter Eingang (Plus-Eingang) des zweiten Komparators K2 ist an den zweiten Pin P12 des ersten Chips IC1 bzw. an den Source-Anschluss S des Lasttransistors T1 angeschlossen. Der zweite Komparator K2 regelt den Widerstand der Drain-Source-Strecke des Regeltransistors T3 derart, dass das Source-Potential des Lasttransistors T1 und das Source-Potential des Stromfühltransistors T2 übereinstimmen, so dass der Lasttransistor T1 und der Stromfühltransistor T2 im selben Arbeitspunkt betrieben werden. Der Laststrom Iₛ des Stromfühltransistors T2 ist dann proportional zu dem Laststrom I_{L} des Lasttransistors T1.

An dem Stromfühlwiderstand Rs ist ein Spannungssignal Isl abgreifbar, welches proportional zu dem Strom-Sense-Strom Iₛ bzw. dem Laststrom I_{L} des Lasttransistors T1 ist.

Die Schalteranordnung S gemäß Figur 3 weist neben dem Komparator K1 erste und zweite Transistoren S1a, S1b auf, welche als p-Kanal-Transistoren ausgebildet sind und deren Gate-Anschlüsse G an den Ausgang des Komparators K1 angeschlossen sind. Source-Anschlüsse S des ersten und zweiten Transistors S1a, S1b sind an das Versorgungspotential Vdd angeschlossen. Der Drain-Anschluss des ersten Transistors S1a ist an das Gate G des Regeltransistors T3 angeschlossen. Sperrt der erste Transistor S1a, so funktioniert die Anordnung aus dem Komparator K2, dem Transistor T3 und dem Stromfühlwiderstand Rs wie oben beschrieben. Leitet der erste Transistor S1a, so liegt das Gate des dritten Transistors T3 an Versorgungspotential Vdd, wodurch der dritte Transistor T3 sperrt, so daß der Laststrom Iₛ nicht mehr durch den Stromfühlwiderstand Rs fließt und das Stromsignal Us1 auf Null absinkt. Der erste Transistor S1a und der zweite Transistor S1b leiten solange, solange die Drain-Source-Spannung UDS1 des Lasttransistors T1 kleiner als die Referenzspannung Uref ist.

Strom-Sense-Anordnungen wie die, welche sich aus der Schaltungsanordnung der Auswerteschaltung BL1 nach Figur 3 und dem Stromfühlwiderstand T2 ergibt, funktionieren nur dann mit ausreichender Genauigkeit, das heißt liefern nur dann ein Spannungssignal Is1, welches proportional zu dem Laststrom I_{L} ist, wenn sich der Lasttransistor T1 noch nicht in Sättigung befindet, solange der Laststrom I_{L} also proportional zu der Drain-Source-Spannung UDS1 ansteigt.

Übersteigt die Drain-Source-Spannung UDS1 des Lasttransistors T1 den Wert Referenzspannung Uref den Wert der Referenzspannung Uref, die vorzugsweise derart gewählt, daß sie kleiner als die Sättigungsspannung des Lasttransistors T1 ist, so kann der Laststrom Iₛ mittels der Schalteranordnung SW zu der zweiten Auswerteschaltung umgeschaltet werden. Auf diese Weise ist sichergestellt, daß nur dann ein Stromsignal Us1 durch die erste Auswerteschaltung BL1 erzeugt wird, solange sich der Lasttransistor T1 noch nicht in Sättigung befindet und solange die Strom-Sense-Anordnung ein zu dem Laststrom des Lasttransistors T1 proportionales Signal Us1 liefern kann.

Die zweite Auswerteschaltung BL2 weist eine Reihenschaltung eines Widerstandes R2 und eines n-Kanal-Transistors T4 auf, wobei diese Reihenschaltung ebenfalls an den Anschlusspin P21 des zweiten Chips IC2 angeschlossen ist. Der Gate-Anschluß G des Transistors T4 ist an den Source-Anschluss des Transistors S1b der Schalteranordnung angeschlossen und über einen Widerstand R1 an Bezugspotential GND gelegt. Leitet der zweite Transistor S1b, so liegt annähernd die gesamte Versorgungsspannung Vdd über dem Widerstand R1 an, wodurch der Transistor T4 leitet. Der Transistor T4 sperrt, wenn auch der zweite Transistor S1b sperrt. Der vierte Transistor T4 leitet also, wenn der Regeltransistor T3 sperrt und der vierte Transistor T4 sperrt, wenn der Regeltransistor T3 leitet. Auf diese Weise ist sichergestellt, daß der Laststrom Iₛ des Stromfühlwiderstandes T2 entweder nur in die erste Auswerteschaltung BL1 oder nur in die zweite Auswerteschaltung BL2 fließt.

Die erste Auswerteschaltung BL1 liefert ein von dem Laststrom L_{L} proportionales Signal Us1 solange sich der Lasttransistor T1 noch nicht in Sättigung befindet bzw. solange die Drain-Source-Spannung UDS1 kleiner als die Referenzspannung Uref ist. Übersteigt die Drain-Source-Spannung UDS1 die Referenzspannung Uref, so fließt der Laststrom Iₛ des Stromfühltransistors T2 in die zweite Auswerteschaltung BL2, wo dieser Laststrom Iₛ über dem zweiten Widerstand R2 einen Spannungsabfall Us2 erzeugt, welcher als zweites Stromsignal Us2 zur Einstellung der Ansteuerspannung (Gate-Source-Spannung) des Lasttransistors T1 herangezogen werden kann. Der Laststrom des Lasttransistors T1 und damit auch der Laststrom des Stromfühltransistors T2 sind im Sättigungsbereich in starkem Maße abhängig von der Gate-Source-Spannung. Abhängig von dem Laststrom des Stromfühlwiderstandes T2 kann über das Stromsignal Us2 dann die Gate-Source-Spannung des Lasttransistors eingestellt werden. Die zweite Ansteuerschaltung BL2 kann insbesondere als Teil einer Strombegrenzungsschaltung dienen, welche die Gate-Source-Spannung des Lasttransistors T1 verringert, wenn der Laststrom einen vorgegebenen Wert überschreitet, was anhand des Spannungssignals Us2 ermittelt werden kann.

### Bezugszeichenliste

- Vdd: Versorgungspotential
- IN: Eingangsklemme
- D: Drain-Anschluss
- G: Gate-Anschluß
- S: Source-Anschluss
- UDS1, UDS2: Drain-Source-Spannung
- Uref: Referenzspannung
- K1: Komparator
- P11, 21, P12: Anschlusspins
- BD: Bonddraht
- Z_{L}: Last
- BL1, BL2: Auswerteschaltungen
- IC1, IC2: integrierte Schaltungen
- Us1: erstes Stromsignal
- Rs: Stromfühlwiderstand
- K2: Komparator
- T2: Transistor
- S1a, S1b: Transistoren
- R1, R2: Widerstände
- T4: Widerstand
- Us2: zweites Stromsignal

## Patentansprüche

1. Schaltungsanordnung mit einem Lasttransistor (T1) und einem an den Lasttransistor (T1) gekoppelten Stromfühltransistor (T2),
**dadurch gekennzeichnet, dass**
dem Stromfühltransistor (T2) eine Schalteranordnung (SW) mit wenigstens einem ersten Schalter (S1; S1a, S1b) nachgeschaltet ist, die abhängig von einer Spannung (UDS) über der Laststrecke (D-S) des Lasttransistors (T1) angesteuert ist um einen Ausgangsstrom (Iₛ) des Stromfühltransistors (T2) abhängig von dieser Spannung (UDS) einer ersten oder einer zweiten Verarbeitungseinheit (BL1, BL2) zuzuführen.

2. Schaltungsanordnung nach Anspruch 1, bei der der Lasttransistor (T1) und der Stromfühltransistor (T2) in einem ersten Chip (IC1) integriert sind und bei der die Schalteranordnung (SW) und die erste und zweite Auswerteschaltung (BL1, BL2) in einem zweiten Chip (IC2) integriert sind.

3. Schaltungsanordnung nach einem der vorangehenden Ansprüche, bei der die Schalteranordnung (S) eine Vergleicheranordnung (K1) aufweist, die die Laststreckenspannung des Lasttransistors (T1) mit einer Referenzspannung (Uref) vergleicht.

4. Schaltungsanordnung nach Anspruch 3, bei der der erste Schalter (S1; S1a, S1b) abhängig von einem Ausgangssignal (AS) der Vergleicheranordnung (K1) angesteuert ist.

5. Schaltungsanordnung nach einem der vorangehenden Ansprüche, bei der der erste Schalter (S1a, S1b) einen ersten und einen zweiten Transistor (S1a, S1b) aufweist, die abhängig von dem Ausgangssignal der Vergleicheranordnung (K1) angesteuert sind.

6. Schaltungsanordnung nach einem der vorangehenden Ansprüche, bei der die erste Auswerteschaltung (BL1) eine zweite Vergleicheranordnung (K2) und einen mittels der Vergleicheranordnung (K2) regelbaren Widerstand (T3) aufweist, der in Reihe zu dem Stromfühltransistor (T2) geschaltet ist.

7. Schaltungsanordnung nach Anspruch 6, bei der die zweite Verarbeitungseinheit (BL2) in Reihe zu dem regelbaren Widerstand (T3) einen weiteren Widerstand (R1) aufweist, an dem ein erstes Stromsignal (Us1) abgreifbar ist.

8. Schaltungsanordnung nach Anspruch 6 oder 7, bei der der regelbare Widerstand (T3) als Transistor ausgebildet ist.

9. Schaltungsanordnung nach einem der vorangehenden Ansprüche, bei der die zweite Verarbeitungseinheit (BL2) eine Reihenschaltung eines zweiten Widerstands (R2) und eines zweiten Schalters (T4) in Reihe zu dem Stromfühltransistor (T2) aufweist.

10. Schaltungsanordnung nach Anspruch 9, bei dem der zweite Schalter (T4) abhängig von einer Schalterstellung der Schalteranordnung (S2; S2a, S2b) angesteuert ist.

11. Schaltungsanordnung nach einem der vorangehenden Ansprüche, bei der eine Laststrecke des ersten Transistors (Sla) zwischen einer Klemme für ein Versorgungspotential (Vdd) und einem Steueranschluss des regelbaren Widerstandes (T3) verschaltet ist.

12. Schaltungsanordnung nach einem der vorangehenden Ansprüche, bei der eine Laststrecke des zweiten Transistors (S1b) zwischen einem Versorgungspotential und einem Steueranschluss des zweiten Schalters (T4) verschaltet ist.

## Claims

1. Circuit arrangement having a load transistor (T1) and a current sensing transistor (T2) coupled to the load transistor (T1),
**characterized in that**
a switch arrangement (SW) having at least one first switch (S1; S1a, S1b) is connected downstream of the current sensing transistor (T2), which switch arrangement is driven depending on a voltage (UDS) across the load path (D-S) of the load transistor (T1), in order to feed an output current (Iₛ) of the current sensing transistor (T2) to a first or a second processing unit (BL1, BL2) depending on this voltage (UDS).

2. Circuit arrangement according to Claim 1, in which the load transistor (T1) and the current sensing transistor (T2) are integrated in a first chip (IC1), and in which the switch arrangement (SW) and the first and second evaluation circuits (BL1, BL2) are integrated in a second chip (IC2).

3. Circuit arrangement according to one of the preceding claims, in which the switch arrangement (S) has a comparator arrangement (K1), which compares the load path voltage of the load transistor (T1) with a reference voltage (Uref).

4. Circuit arrangement according to Claim 3, in which the first switch (S1; S1a, S1b) is driven depending on an output signal (AS) of the comparator arrangement (K1).

5. Circuit arrangement according to one of the preceding claims, in which the first switch (S1a, S1b) has a first and a second transistor (S1a, S1b), which are driven depending on the output signal of the comparator arrangement (K1).

6. Circuit arrangement according to one of the preceding claims, in which the first evaluation circuit (BL1) has a second comparator arrangement (K2) and a resistor (T3), which can be regulated by means of the comparator arrangement (K2) and is connected in series with the current sensing transistor (T2).

7. Circuit arrangement according to Claim 6, in which the second processing unit (BL2) has a further resistor (R1) in series with the regulatable resistor (T3), and a first current signal (Us1) can be tapped off at said further resistor.

8. Circuit arrangement according to Claim 6 or 7, in which the regulatable resistor (T3) is designed as a transistor.

9. Circuit arrangement according to one of the preceding claims, in which the second processing unit (BL2) has a series circuit comprising a second resistor (R2) and a second switch (T4) in series with the current sensing transistor (T2).

10. Circuit arrangement according to Claim 9, in which the second switch (T4) is driven depending on a switch position of the switch arrangement (S2; S2a, S2b).

11. Circuit arrangement according to one of the preceding claims, in which a load path of the first transistor (S1a) is connected up between a terminal for a supply potential (Vdd) and a control terminal of the regulatable resistor (T3).

12. Circuit arrangement according to one of the preceding claims, in which a load path of the second transistor (S1b) is connected up between a supply potential and a control terminal of the second switch (T4).

## Revendications

1. Circuit présentant un transistor de puissance (T1) et un transistor de détection de courant (T2) couplé au transistor de puissance (T1),
**caractérisé en ce qu'**
un dispositif de commutateurs (SW) présentant au moins un premier commutateur (S1 ; S1a, S1b) est connecté en aval du transistor de détection de courant (T2), et est commandé en fonction d'une tension (UDS) appliquée sur l'espace de charge (D-S) du transistor de puissance (T1), afin d'envoyer un courant de sortie (Is) du transistor de détection de courant (T2) en fonction de cette tension (UDS) à une première ou à une seconde unité de traitement (BL1, BL2).

2. Circuit selon la revendication 1,
**caractérisé en ce que**
le transistor de puissance (T1) et le transistor de détection de courant (T2) sont intégrés dans une première puce (IC1), et le dispositif de commutateurs (SW) et le premier et le second circuit d'exploitation (BL1, BL2) sont intégrés dans une seconde puce (IC2).

3. Circuit selon l'une quelconque des revendications précédentes,
**caractérisé en ce que**
le dispositif de commutateurs (S) présente un dispositif de comparateurs, qui compare la tension de l'espace de charge du transistor de puissance (T1) à une tension de référence (Uref).

4. Circuit selon la revendication 3,
**caractérisé en ce que**
le premier commutateur (S1 ; S1a, S1b) est commandé en fonction d'un signal de sortie (AS) du dispositif de comparateurs (K1).

5. Circuit selon l'une quelconque des revendications précédentes;
**caractérisé en ce que**
le premier commutateur (S1a, S1b) présente un premier et un second transistor (S1a, S1b), qui sont commandés en fonction du signal de sortie du dispositif de comparateurs (K1).

6. Circuit selon l'une quelconque des revendications précédentes,
**caractérisé en ce que**
le premier circuit d'exploitation (BL1) présente un second dispositif de comparateurs (K2) et une résistance (T3) réglable au moyen du dispositif de comparateurs (K2), qui est connectée en série avec le transistor de détection de courant (T2).

7. Circuit selon la revendication 6,
**caractérisé en ce que**
la seconde unité de traitement (BL2) présente en série avec la résistance réglable (T3) une résistance supplémentaire R1, au niveau de laquelle on peut mesurer un premier signal de courant (Us1).

8. Circuit selon la revendication 6 ou 7,
**caractérisé en ce que**
la résistance réglable (T3) est réalisée sous forme de transistor.

9. Circuit selon l'une quelconque des revendications précédentes,
**caractérisé en ce que**
la seconde unité de traitement (BL2) présente un montage en série composé d'une seconde résistance (R2) et d'un second commutateur (T4) en série avec le transistor de détection de courant (T2).

10. Circuit selon la revendication 9, dans lequel le second commutateur (T4) est commandé en fonction de la position de commutation du dispositif de commutateurs (S2 ; S2a, S2b).

11. Circuit selon l'une quelconque des revendications précédentes,
**caractérisé en ce que**
un espace de charge du premier transistor (S1a) est connecté entre une borne prévue pour un potentiel d'alimentation (Vdd) et une gâchette de la résistance réglable (T3).

12. Circuit selon l'une quelconque des revendications précédentes,
**caractérisé en ce que**
un espace de charge du second transistor (S1b) est connecté à un potentiel d'alimentation et une gâchette du second commutateur (T4).
